# EUROPEAN PATENT SPECIFICATION

(11) **EP 1 451 648 B1**
(45) Date of publication and mention of the grant of the patent: **28.03.2007**
(21) Application number: 02750399.4
(22) Date of filing: 02.08.2002
(51) Int. Cl.: G05B 1/00

(54) **ENVELOPE MODULATOR FOR HAPTIC FEEDBACK DEVICES**
HÜLLENMODULATOR FÜR HAPTISCHE RÜCKMELDEEINRICHTUNGEN
MODULATEUR D'ENVELOPPE POUR DISPOSITIFS HAPTIQUES DE RETROACTION

(30) Priority: 02.08.2001 US 309913 P
(43) Date of publication of application: 01.09.2004
(73) Proprietor: Immersion Corporation, San Jose, CA 95131 (US)
(72) Inventor: TIERLING, Kollin, M., San Jose, CA 95131 (US)
(74) Representative: Haley, Stephen
(86) International application number: PCT/US2002/024534
(87) International publication number: WO 2003/012558

(56) References cited:
- US-A- 4 771 344
- US-A- 5 103 404
- US-A- 5 436 622
- US-A- 5 649 020
- US-A- 5 684 722
- US-A- 5 734 236
- US-A- 5 767 839
- US-A- 5 952 806
- US-B1- 6 216 059
- US-B1- 6 219 034

## Description

### BACKGROUND OF THE INVENTION

The present invention relates generally to the control of haptic feedback interface devices that interface a user with a computer device.

Humans interface with electronic and mechanical devices in a variety of applications, and the need for a more natural, easy-to-use, and informative interface is a constant concern. In the context of the present invention, humans interface with computer devices for a variety of applications. One such application is interacting with computer-generated environments such as games, simulations, and application programs. Computer input devices such as mice and trackballs are often used to control a cursor within a graphical environment and provide input in these applications. In portable computer or electronic devices, such as laptop computers or personal digital assistants (PDAs), mice typically have too large a workspace to be practical. A popular device for portable computers are "touchpads," or touchscreens, which are small rectangular, planar pads that sense the location of a pointing object by any of a variety of sensing technologies.

In some interface devices, haptic feedback is also provided to the user. These types of interface devices can provide physical sensations which are felt by the user manipulating the user object of the interface device. One or more motors or other type of actuators are coupled to the device housing or manipulandum and are connected to the controlling computer system. The computer system controls forces output by the actuators in conjunction and coordination with displayed events. The computer system can thus convey physical force sensations to the user in conjunction with other supplied feedback as the user is grasping or contacting the interface device or manipulatable object.

In many haptic feedback devices, the haptic-feedback takes the form of vibrations, jolts, or pulses output on the housing or manipulandum and are thus experienced by the user, referred to as "tactile" sensations herein. For example, many gamepad devices include a spinning eccentric mass that creates inertial vibrations on the housing or object. Other devices, such as the I-Feel Mouse from Logitech Corp., provide inertial vibrations using a linearly-moving mass. Still other devices may vibrate a;housing or object by impacting or directly moving the housing or object with the actuator.

One problem with current haptic feedback devices is that tactile sensations output to the user tend to be more effective in particular frequency ranges and are less effective in other frequency ranges, thus causing haptic sensations to feel uneven and inconsistent to the user over broad frequency ranges.

US-A-4771344 discloses a circuit including a reference oscillator, amplitude modulator, envelope generator and haptic feedback device.

In accordance with one aspect of the present invention, there is provided an amplitude modulator circuit comprising:
a reference oscillator;
an envelope modulator coupled to the reference oscillator for receiving a reference signal;
a microcontroller coupled to the envelope modulator for providing an envelope signal to the envelope modulator
a low pass filter coupled to the envelope modulator for receiving a modulated command from the envelope modulator;
an inverter coupled to the low pass filter for receiving a low passed envelope modulated signal from the low pass filter; and
a transducer or amplifier coupled to the inverter and the low pass filter for receiving an inverted low passed signal and the low passed envelope modulated signal

In accordance with another aspect of the present invention, the reference oscillator comprises a sine waver generator.

ln accordance with a further aspect of the present invention, the envelope modulator comprises a ramp generator circuit.

In accordance with yet another aspect of the present invention, the low pass filter is a second order low pass filter.

The present invention also provides a method of amplitude modulation of a resonant frequency sinusoid by a pulse width modulator envelope function, the method comprising:
providing an envelope wave shape to an envelope modulator;
providing a sinusoidal reference signal to the envelope modulator;
providing a modulated command from the envelope modulator to a low pass filter;
providing a low passed modulated command signal from the low pass filter to an inverter; and a transducer or amplifier; and
providing an inverted low passed modulated command signal from the inverter to the transducer or amplifier passed modulated command signal.

Other features and advantages of the present invention will be understood upon reading and understanding the description of the preferred exemplary embodiments, found herein below, in conjunction with reference to the drawings, in which numerals represent like elements.

### BRIEF DESCRIPTION OF THE DRAWINGS

Figure 1 is a schematic view illustrating a design topology of an embodiment of a circuit in accordance with the present invention; and

Figure 2 is a schematic of an example of a circuit in accordance with the present invention.

### DESCRIPTION OF SPECIFIC PREFERRED EXEMPLARY EMBODIMENTS

The present invention is an alternative embodiment of an envelope modulation approach referred to in patent application no. 09/908,184, filed July 17, 2001, which is incorporated herein by reference in its entirety for all purposes. That invention as well as the one described herein, provides methods used to modulate a high frequency signal, suitable for driving a vibrotactile transducer, with a lower frequency signal that contains tactile information. The composite or modulated signal is used to drive an actuator that conveys the lower frequency tactile information to the human user via electrical amplification that drives a transducer, thereby mechanically conveying the tactile information to the user. The high frequency signal oscillates at a frequency that is close to the resonant frequency of the mechanical actuator driven by the transducer, and hence the haptic sensations benefit from mechanical amplification caused by the resonant signal. In patent application 09/908,184, one methodology described is to multiply a resonant frequency sinusoid by the modulating envelope. The amplitude modulated sinusoid then commands an amplifier as a pulse width modulated signal.

A conventional approach requires that the pulse width modulated (PWM) frequency be updated at a high rate in order to accurately conform to a sinusoidal resonant frequency waveform. Deviations from a pure sinusoid generate audible noise in the actuator that detracts from the actuator as a tactile device. A high PWM update rate would be necessary to accurately command a sinusoid that may be in the 100 to 200 Hz range. Such a high update rate would consume significant processor duty cycle and potentially require a more costly processor than with the invention described herein.

The present invention describes amplitude modulation of a resonant frequency sinusoid by a pulse width modulated envelope function to provide strong haptic sensations over a broad frequency range.

A preferred embodiment of the present inventive approach is to use an electronic circuit to perform the envelope modulation function so that the processor only needs to command the envelope wave shape, which is a much lower frequency signal that requires a lower processor update rate. Use of a single electronic circuit reduces costs of the device, since separate components such as op amps or other amplifiers are not required.

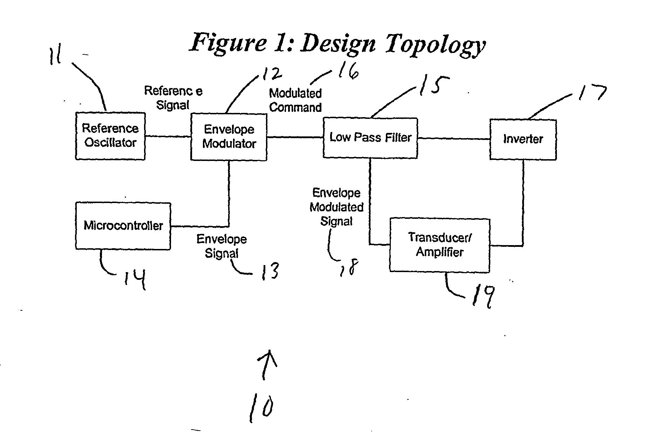

Figure 1 illustrates a design topology of one embodiment of the present invention. The inventive circuit topology 10 includes a signal generator ("reference oscillator") 11 that produces a sinusoidal reference signal with a frequency that is the same as (or close to) the mechanical resonant frequency of the tactile actuator. If the mechanical system has more than one resonant frequency, one of the resonant frequencies is chosen at which the oscillator will provide the signal. An actuator, such as a piezoelectric actuator or other actuator driving an oscillating mass or manipulandum, typically has a resonant frequency at which output forces (vibrations) are strongest due to the mechanical properties of the system. It is this resonant frequency at which the actuator is preferably driven.

The circuit topology of Fig. 1 also includes an envelope modulator 12 that amplitude modulates the reference signal output by the reference oscillator with an envelope signal 13 from a microcontroller (processor) 14, such as a microprocessor, state machines, etc. The envelope signal can include haptic effects or features that are desired to be output to the user, such as a jolt, a vibration of a desired frequency, etc. A low pass filter 15 receives modulated command 16 output by the envelope modulator. The low pass filter removes the high frequency content of the command envelope signal from the processor. An inverter 17 receives the low passed signal from the filter to provide a differential output signal. The low passed envelope modulated signal 18 from the low pass filter is also sent to a transducer or amplifier 19, such as a piezo transducer or motor amplifier. The inverted low passed signal from the inverter is also sent to the transducer or amplifier so that a differential drive signal is provided to the transducer or amplifier. Other embodiments can produce a single ended signal that either drives the transducer directly or indirectly through an amplifier.

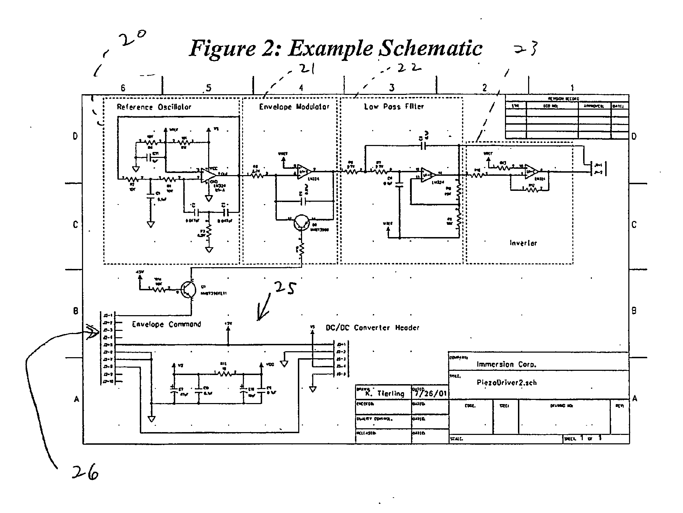

Figure 2 illustrates an example of a more detailed embodiment of the present invention. This embodiment consists of four circuits. The first circuit is a sine wave generator (reference oscillator) 20. The sine wave generator produces a reference sinusoidal function with a frequency that is the same as (or close to) a mechanical resonant frequency of the actuator. This reference signal is one of the two signals used by the second circuit. The signal generator is preferably a free-running oscillator that is formed by a double integrating feedback loop.

The second circuit is an envelope modulator 21 that generates a series of pulses at the processor's PWM frequency (for example, nominally 24 kHz) with an amplitude that is proportional to the instantaneous voltage of the reference sinusoid. This circuit is preferably a ramp generator that is reset when the PWM signal is low. When the PWM signal is high, the ramp generator produces a sawtooth output signal with an output voltage that increases linearly in time at a rate that is proportional to the instantaneous voltage of the reference sinusoid. In this way, the circuit produces a series of sawtooth pulses with a width proportional to the PWM duty cycle and height proportional to the instantaneous voltage of the reference sinusoid. The average voltage of the sawtooth signal is therefore the same as a signal that would be produced by directly multiplying the reference sinusoid by the PWM command signal. The sawtooth signal output waveform from this circuit then feeds into the third circuit. An envelope command indicating envelope wave shape is provided by microprocessor 25 at output 26.

The third circuit is a second order low pass filter 22 with a corner frequency that lies between the resonant frequency of the actuator (or mechanical system) and the pulse width modulation frequency of the command signal. The fourth circuit is an inverter 23 that inverts the output of the third circuit. The signals output from the third and fourth circuits constitute a differential drive signal that is modulated at the reference sinusoid frequency and has an amplitude that is proportional to the duty cycle of the commanded PWM signal. This differential drive signal can then drive a piezo transducer directly or be amplified to drive an electric motor (such as a DC motor) or other actuator.

The invention frees the processor from the task of performing the envelope modulation function at a sufficiently high update rate to produce a clean modulated sinusoidal output.

A prototype circuit demonstrated that the circuit was able to drive either one or two piezo transducers, and that a constant frequency sinusoidal waveform was being modulated by the PWM envelope command from a TouchSense processor. The prototype circuit further demonstrated that the generated waveform was exciting an inertially grounded mass/transducer/spring system at its mechanical resonant frequency. The frequency of the sinusoidal driving function was tuned to the resonant frequency of the mechanical system. The tactile sensation felt when touching the mass in the mechanical system conveyed the impression that it was excited at the much lower envelope function frequency rather than the mechanical system's resonant frequency.

The present invention is suitable to drive actuators to provide haptic sensations in a variety of haptic feedback computer interface devices, including mice, joysticks, trackballs, gamepads, remote controls, PDA's, touchpads for laptop computers, touchscreens for a variety of devices, gloves, steering wheels, etc. Some examples of suitable devices and haptic sensations are described in copending application no. 09/917,263, filed 7/26/01, entitled, "Haptic Interface for Laptop Computers and Other Portable Devices," including piezoelectric transducer embodiments, and which is incorporated herein by reference in its entirety for all purposes. Other tactile devices and sensations used for inertial tactile feedback, and suitable for use with the present invention, are described in Patent Nos. 6,211,861 and 6,088,019 and application nos. 09/585,741, and 09/487,737, all incorporated herein by reference in their entirety for all purposes. Other interface device embodiments suitable for use with the present invention are described in 09/759,780, 60/236,417, and 60/236,558, incorporated by reference herein in their entirety for all purposes.

While this invention has been described in terms of preferred exemplary embodiments, there are alterations, modifications, and permutations thereof which fall within the scope of this invention. It should also be noted that the embodiments described above can be combined in various ways in a particular implementation. Furthermore, certain terminology has been used for the purposes of descriptive clarity, and not to limit the present invention.

## Claims

1. An amplitude modulator circuit comprising:
a reference oscillator (11);
an envelope modulator (12) coupled to the reference oscillator for receiving a reference signal;
a microcontroller coupled to the envelope modulator for providing an envelope signal to the envelope modulator
a low pass filter (15) coupled to the envelope modulator for receiving a modulated command from the envelope modulator;
an inverter (17) coupled to the low pass filter for receiving a low passed envelope modulated signal from the low pass filter; and
a transducer (19) coupled to the inverter and the low pass filter for receiving an inverted low passed signal and the low passed envelope modulated signal.

2. An amplitude modulator circuit in accordance with claim 1 wherein the reference oscillator (11) comprises a sine wave generator.

3. An amplitude modulator circuit in accordance with claim 1 wherein the envelope modulator (12) comprises a ramp generator circuit.

4. An amplitude modulator circuit in accordance with claim 1, wherein the low pass filter (15) in a second order low pass filter.

5. A method of amplitude modulation of a resonant frequency sinusoid by a pulse width modulator envelope function, the method comprising:
providing an envelope wave shape to an envelope modulator (12);
providing a sinusoidal reference signal to the envelope modulator;
providing a modulated command from the envelope modulator to a low pass filter (15);
providing a low passed modulated command signal from the low pass filter to an inverter (17); and a transducer or amplifier (19); and
providing an inverted low passed modulated command signal from the inverter to the transducer or amplifier passed modulated command signal.

6. A method in accordance with claim 5, wherein the reference oscillator comprises a sine wave generator.

7. A method in accordance with claim 5, wherein the envelope modulator comprises a ramp generator circuit.

8. A method in accordance with claim 5, wherein the low pass filter is a second order low pass filter.

## Patentansprüche

1. Amplitudenmodulatorschaltkreis mit:
einem Referenzoszillator (11);
einem Hüllkurvenmodulator (12), der mit dem Referenzoszillator gekoppelt ist, um einen Referenzsignal zu empfangen;
einem Mikrocontroller, der mit dem Hüllkurvenmodulator gekoppelt ist, um dem Hüllkurvenmodulator ein Hüllkurvensignal bereit zu stellen;
einem Tiefpassfilter (15), der mit dem Hüllkurvenmodulator gekoppelt ist, um einen modulierten Steuerbefehl von dem Hüllkurvenmodulator zu empfangen;
einem Inverter (17), der mit dem Tiefpassfilter gekoppelt ist, um ein tiefpassgefiltertes moduliertes Hüllkurvensignal von dem Tiefpassfilter zu empfangen; und
einem Wandler (19), der mit dem Inverter und dem Tiefpassfilter gekoppelt ist, um ein invertiertes tiefpassgefiltertes Signal und das tiefpassgefilterte modulierte Hüllkurvensignal zu empfangen.

2. Amplitudenmodulatorschaltkreis nach Anspruch 1, bei dem der Referenzoszillator (11) einen Sinuswellengenerator umfasst.

3. Amplitudenmodulatorschaltkreis nach Anspruch 1, bei dem der Hüllkurvenmodulator (12) einen Sägezahngeneratorschaltkreis umfasst.

4. Amplitudenmodulatorschaltkreis nach Anspruch 1, bei dem das Tiefpassfilter (15) ein Tiefpassfilter zweiter Ordnung ist.

5. Verfahren zur Amplitudenmodulation einer Resonanzfrequenzsinuswelle durch eine Pulsbreitenmodulatorhüllkurvenfunktion, wobei das Verfahren umfasst:
Bereitstellen einer Hüllkurvenwellenform einem Hüllkurvenmodulator (12);
Bereitstellen eines sinusförmigen Referenzsignals dem Hüllkurvenmodulator;
Bereitstellen eines modulierten Steuerbefehls von dem Hüllkurvenmodulator zu einem Tiefpassfilter (15);
Bereitstellen eines tiefpassgefilterten modulierten Steuerbefehlssignals ausgehend von dem Tiefpassfilter zu einem Inverter (17) und einem Wandler oder Verstärker (19); und
Bereitstellen eines invertierten tiefpassgefilterten modulierten Steuerbefehlssignals ausgehend von dem Inverter zu dem Wandler oder Verstärker, der das modulierte Steuerbefehlssignal durchgelassen hat.

6. Verfahren nach Anspruch 5, bei dem der Referenzoszillator einen Sinuswellengenerator umfasst.

7. Verfahren nach Anspruch 5, bei dem der Hüllkurvenmodulator einen Sägezahngeneratorschaltkreis umfasst.

8. Verfahren nach Anspruch 5, bei dem das Tiefpassfilter ein Tiefpassfilter zweiter Ordnung ist.

## Revendications

1. Circuit modulateur d'amplitude, comprenant:
un oscillateur de référence (11) ;
un modulateur d'enveloppe (12) couplé à l'oscillateur de référence pour recevoir un signal de référence ;
un microcontrôleur couplé au modulateur d'enveloppe pour procurer un signal d'enveloppe au modulateur d'enveloppe ;
un filtre passe-bas (15) couplé au modulateur d'enveloppe pour recevoir une commande modulée du modulateur d'enveloppe ;
un convertisseur (17) couplé au filtre passe-bas pour recevoir le signal d'enveloppe modulé, passe-bas du filtre passe-bas, et
un transducteur (19) couplé au convertisseur et au filtre passe-bas pour recevoir un signal converti passe-bas et le signal d'enveloppe modulé, passe-bas.

2. Circuit modulateur d'amplitude selon la revendication 1, où l'oscillateur de référence (11) comprend un générateur d'onde sinusoïdale.

3. Circuit modulateur d'amplitude selon la revendication 1, où le modulateur d'enveloppe (12) comprend un circuit générateur de rampe.

4. Circuit modulateur d'amplitude selon la revendication 1, où le filtre passe-bas (15) est un filtre passe-bas de deuxième ordre.

5. Procédé de modulation d'amplitude d'une sinusoïde de fréquence de résonance par une fonction d'impulsion d'enveloppe de modulateur de largeur, le procédé comprenant :
l'introduction d'une forme d'onde d'enveloppe dans un modulateur d'enveloppe (12) ;
l'introduction d'un signal sinusoïdal de référence dans le modulateur d'enveloppe ;
l'introduction d'une commande modulée depuis le modulateur d'enveloppe dans un filtre basse-bas (15) ;
l'introduction d'un signal de commande modulé, passe-bas du filtre passe-bas dans un convertisseur (17) ; et un transducteur ou amplificateur (19) ; et
l'introduction d'un signal de commande modulé, passe-bas, converti, du convertisseur dans le transducteur ou d'un signal de commande modulé, passe-bas, amplifié.

6. Procédé selon la revendication 5, dans lequel l'oscillateur de référence comprend un générateur d'onde sinusoïdale.

7. Procédé selon la revendication 5, dans lequel le modulateur d'enveloppe comprend un circuit de générateur de rampe.

8. Procédé selon la revendication 5, dans lequel le filtre passe-bas est un filtre passe-bas de deuxième ordre.
